# EUROPEAN PATENT APPLICATION

(11) **EP 4 827 100 A2**
(43) Date of publication of application: **21.10.2026**
(21) Application number: 26194638.8
(22) Date of filing: 08.06.2021
(51) Int. Cl.: H04N 23/52

(54) **CAMERA MODULE**

(30) Priority: 12.06.2020 KR 20200071622
(62) Document number(s) of the earlier application(s) in accordance with Art. 76 EPC: 21822628.0 / 4 167 560
(71) Applicant: LG Innotek Co., Ltd., Seoul 07796 (KR)
(72) Inventor: CHOI, Jong Cheol, Seoul 07796 (KR); KIM, Ohk Sung, Seoul 07796 (KR); MOON, Seong Deok, Seoul 07796 (KR)
(74) Representative: DREISS Patentanwälte PartG mbB

(57) **Abstract**

The present invention relates to a camera module comprising: a first body including a lens; a second body coupled to the first body; and a substrate assembly disposed within the second body, wherein the substrate assembly comprises: a first substrate and a second substrate; a third substrate disposed between the first substrate and the second substrate; a fourth substrate electrically connecting the first substrate and the second substrate; a fifth substrate electrically connecting the second substrate and the third substrate; and a processor disposed on the second substrate, wherein the length of the fourth substrate is longer than the length of the fifth substrate.

## Description

### [Technical Field]

The present embodiment relates to a camera module.

### [Background Art]

Recently, ultra-small camera modules are being developed, and ultra-small camera modules are widely used in small electronic products such as smartphones, laptops, and game consoles.

As the spread of automobiles becomes more popular, ultra-small cameras are widely used not only in small electronic products but also in vehicles. For example, black box cameras for vehicle protection or objective data of traffic accidents, rear surveillance cameras that allow drivers to monitor blind spots at the rear of the vehicle through screens to ensure safety when reversing the vehicle, and peripheral detection cameras capable of monitoring the surroundings of the vehicle, and the like are provided.

Recently, as the camera module outputs high-resolution images, the number of substrates is increasing, and the size and number of elements being mounted on the substrate are increasing. At this time, there is a problem with the heat dissipation structure that emits heat to the outside as the heat inside the camera module is increasing due to the increase in the amount of heat generated from the substrate or element being mounted on the substrate.

In particular, the conventional camera module is designed to position the ISP processor generating the highest amount of heat on the second stacked substrate, and in this case, it is difficult to design a structure that can contact the ISP processor and the metal body with high thermal conductivity, so there is a problem that only natural heat dissipation can be done by the internal air.

In addition, since only natural heat dissipation is possible, there is a problem of malfunction such as the camera module being suddenly turned off due to an increase in internal temperature.

### [Detailed Description of the Invention]

### [Technical Subject]

Through this embodiment, it is intended to provide a camera module with improved heat dissipation performance by changing the assembly stack structure of a substrate and disposing the processor close to a metal body.

In addition, it is intended to provide a camera module having a substrate structure advantageous for heat dissipation by contacting a processor with a component having high thermal conductivity by changing the assembly stacking structure of the substrate.

### [Technical Solution]

A camera module according to the present embodiment comprises: a first body including a lens; a second body being coupled to the first body; and a substrate assembly being disposed inside the second body, wherein the substrate assembly comprises: a first substrate and a second substrate; a third substrate being disposed between the first substrate and the second substrate; a fourth substrate electrically connecting the first substrate and the second substrate; a fifth substrate electrically connecting the second substrate and the third substrate; and a processor being disposed on the second substrate, and wherein the length of the fourth substrate may be longer than the length of the fifth substrate.

A camera module according to the present embodiment comprises: a first body including a lens; a second body being coupled to the first body; and a substrate assembly disposed inside the second body, wherein the substrate assembly comprises: a first substrate and a second substrate; a third substrate being disposed between the first substrate and the second substrate; a fourth substrate electrically connecting the first substrate and the second substrate; a fifth substrate electrically connecting the second substrate and the third substrate; and a processor being disposed on the second substrate, and wherein the length of the fourth substrate in an optical axis direction may be longer than the length of the fifth substrate in the optical axis direction.

The processor may be disposed closer to a bottom plate of the second body than the first to fifth substrates.

At least a portion of the fourth substrate may be overlapped with the second substrate in a direction perpendicular to the optical axis direction.

The fourth substrate may be overlapped with the fifth substrate in a direction perpendicular to the optical axis direction.

A connector being disposed on the third substrate is included, and the second substrate may include a groove through which the connector is being penetrated.

At least a portion of the connector may be overlapped with the second substrate in a direction perpendicular to the optical axis direction.

At least a portion of the connector is disposed at a position higher than the second substrate, and the remaining portion of the connector may be disposed at a position lower than the second substrate.

The distance between the first substrate and the second substrate in an optical axis direction may be longer than the distance between the first substrate and the third substrate in the optical axis direction.

The second body includes a bottom plate, a side plate being extended upwardly from the bottom plate, and a heat dissipation pad being disposed between the processor and the bottom plate of the second body, wherein one surface of the heat dissipation pad is in contact with the processor and the other surface of the heat dissipation pad may be in contact with the bottom plate of the second body.

The heat dissipation pad may be formed of a thermally conductive material.

The thickness of the heat dissipation pad in an optical axis direction may be greater than a thickness of the processor in the optical axis direction.

The heat being generated in the processor may be transferred to the heat dissipation pad, and the heat transferred to the heat dissipation pad may be radiated to the outside through the bottom plate of the second body.

The width of the fourth substrate in a direction perpendicular to an optical axis direction may be smaller than the width of the fifth substrate in a direction perpendicular to the optical axis direction.

The first to third substrates includes a rigid printed circuit board, and the fourth to fifth substrates may include a rigid printed circuit board.

The camera module according to the present embodiment comprises: a first body including a lens; a second body being coupled to the first body; and a substrate assembly being disposed inside the second body, wherein the substrate assembly comprises: a first substrate being disposed with an image sensor; a second substrate being spaced apart from the first substrate and being disposed with a processor; and a third substrate being spaced apart from the first and second substrates and being disposed with a connector, and wherein the second substrate may be disposed farther from the lens than the first and third substrates.

The second substrate may be disposed at a lower position than the first and third substrates.

The third substrate may be disposed between the first substrate and the third substrate, and the second substrate may include a groove through which the connector is penetrated.

At least a portion of the connector is disposed at a position higher than the second substrate, and the remaining portion of the connector may be disposed at a position lower than the second substrate.

The distance between the first substrate and the second substrate in an optical axis direction may be longer than the distance between the first substrate and the third substrate in the optical axis direction.

A fourth substrate electrically connecting the first substrate and the second substrate, and a fifth substrate electrically connecting the second substrate and the third substrate are included, and the length of the fourth substrate in an optical axis direction may be longer than the length of the fifth substrate in the optical axis direction.

At least a portion of the fourth substrate may be overlapped with the second substrate in a direction perpendicular to the optical axis direction.

### [Advantageous Effects]

Through the present embodiment, the heat dissipation performance may be improved by changing the assembly stacking structure of the substrate and disposing the processor close to the metal body.

In addition, by changing the assembly and stacking structure of the substrate, the processor may have a substrate structure advantageous for heat dissipation by being contacted with the component with high thermal conductivity.

### [Brief Description of Drawings]

FIG. 1 is a perspective view of a camera module according to the present embodiment when viewed from an upward direction.
FIG. 2 is a perspective view of the camera module according to the present embodiment when viewed from a downward direction.
FIG. 3 is an exploded perspective view of FIG. 1.
FIG. 4 is an exploded perspective view of FIG. 2.
FIG. 5 is a perspective view with a second body of a camera module being removed according to the present embodiment.
FIG. 6 is a front view of a camera module according to the present embodiment.
FIG. 7 is a cross-sectional view taken along line A-A of FIG. 6.
FIG. 8 is a cross-sectional view taken along line B-B of FIG. 6.
FIG. 9 is a perspective view of a substrate assembly of a camera module according to the present embodiment.
FIG. 10 is a perspective view illustrating a substrate assembly and a support member of a camera module according to the present embodiment.
FIG. 11 is an exploded perspective view of FIG. 10.
FIGS. 12 and 13 are views illustrating an unfolded state of first to fifth substrates of a camera module according to the present embodiment.
FIG. 14 is a side view of a substrate assembly of a camera module according to the present embodiment.
FIG. 15 is a diagram illustrating a heat dissipation path of a camera module according to the present embodiment.

### [EMBODIMENT]

Hereinafter, preferred embodiments of the present invention will be described in detail with reference to the accompanying drawings.

However, the technical idea of the present invention is not limited to some embodiments to be described, but may be implemented in various forms, and within the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

The 'optical axis direction' used hereinafter may be defined as an optical axis direction of the lens. Meanwhile, the 'optical axis direction' may correspond to any one among a 'up and down direction', a 'vertical direction', and a 'z axis direction'.

Hereinafter, the camera module **10** according to an embodiment of the present invention will be described in more detail with reference to the accompanying drawings.

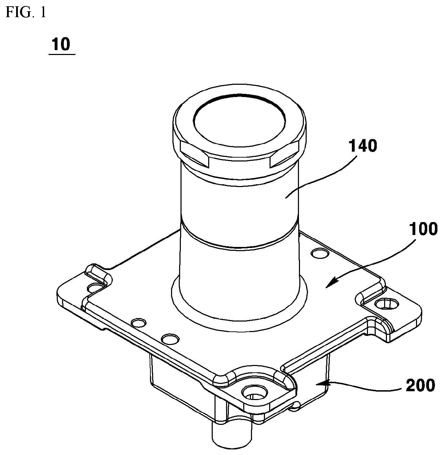

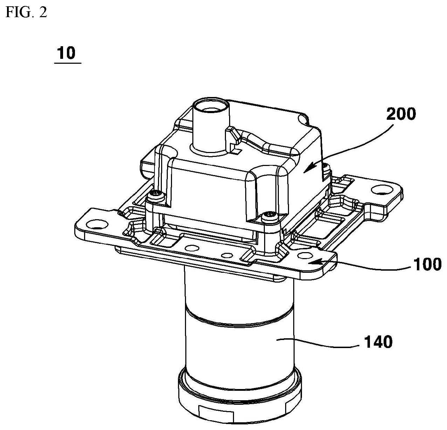

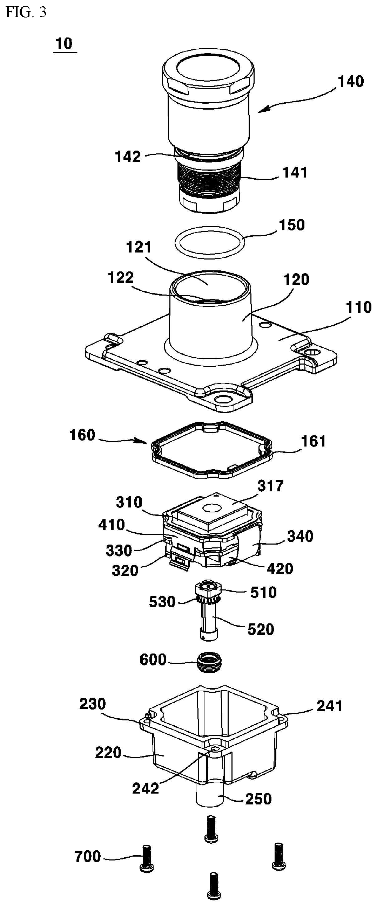

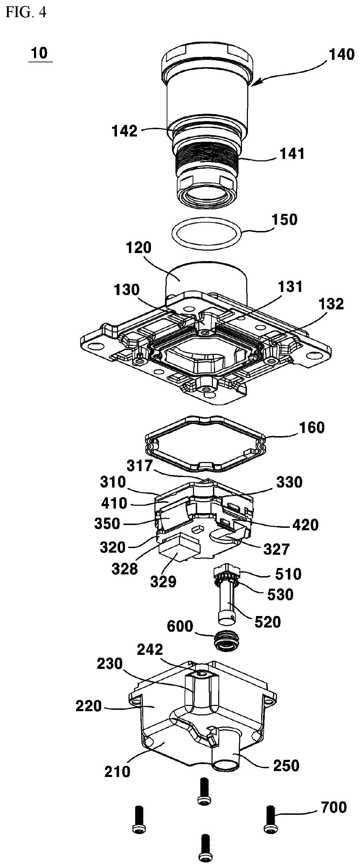

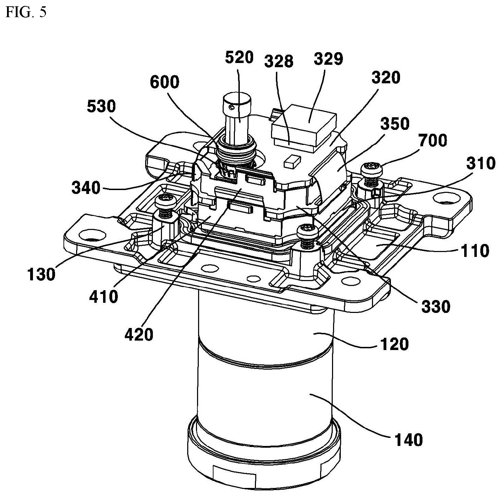

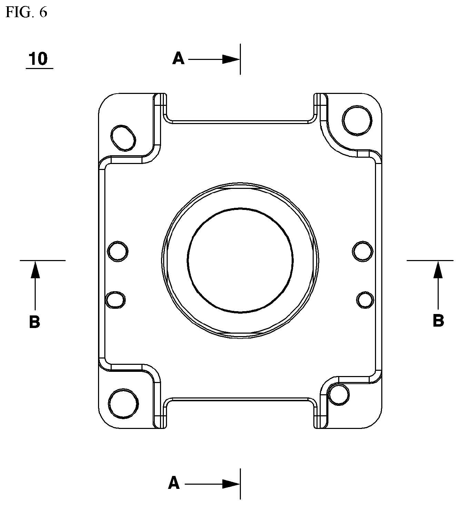

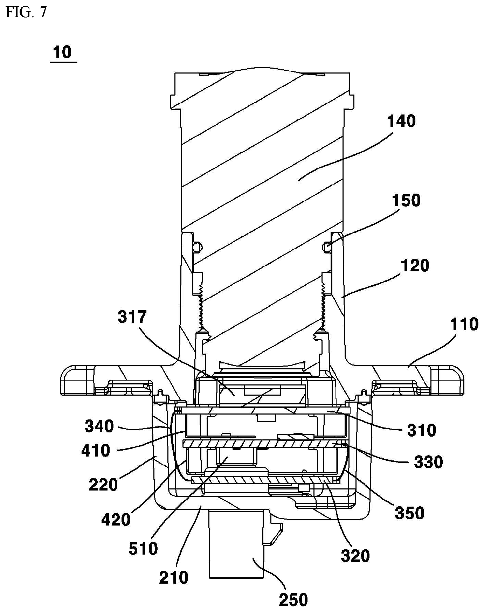

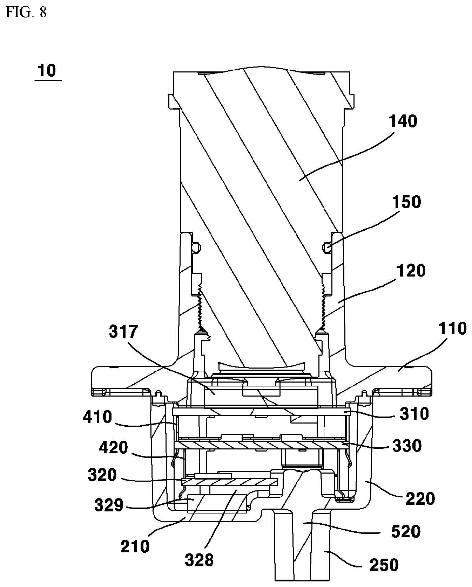

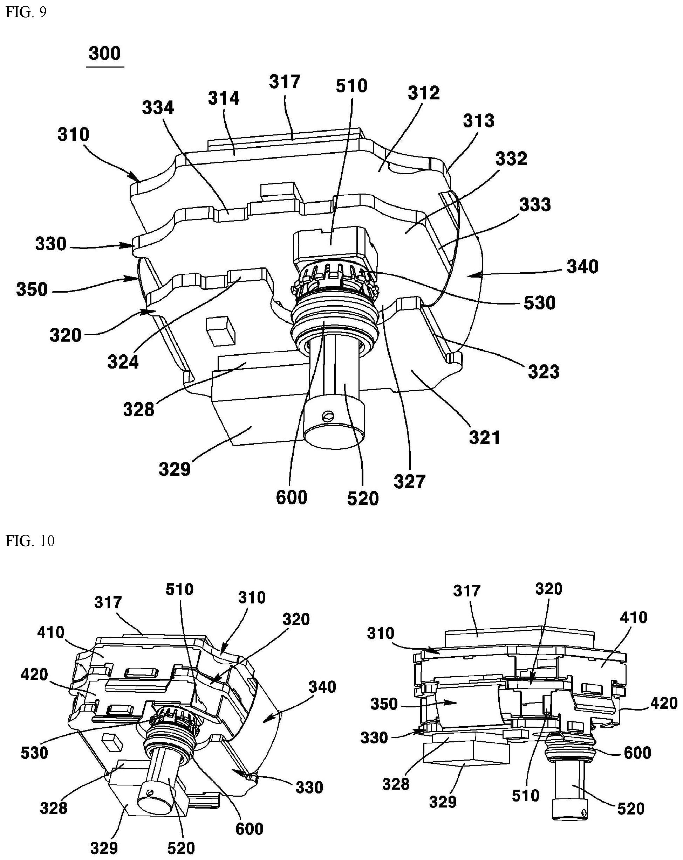

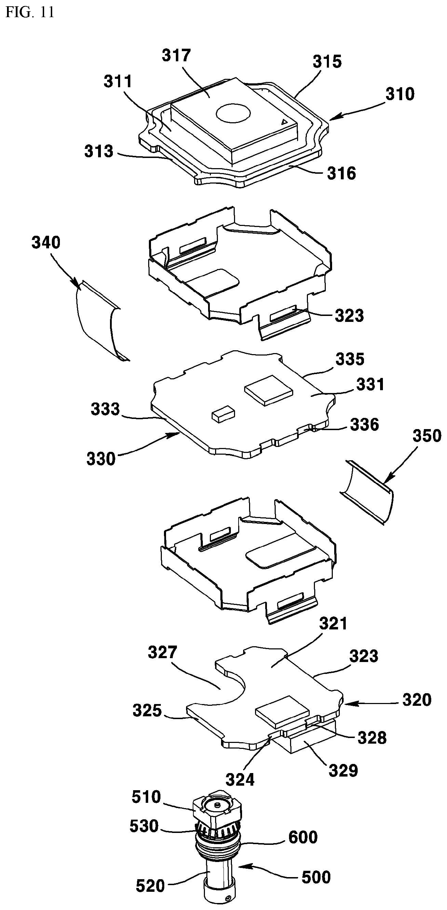

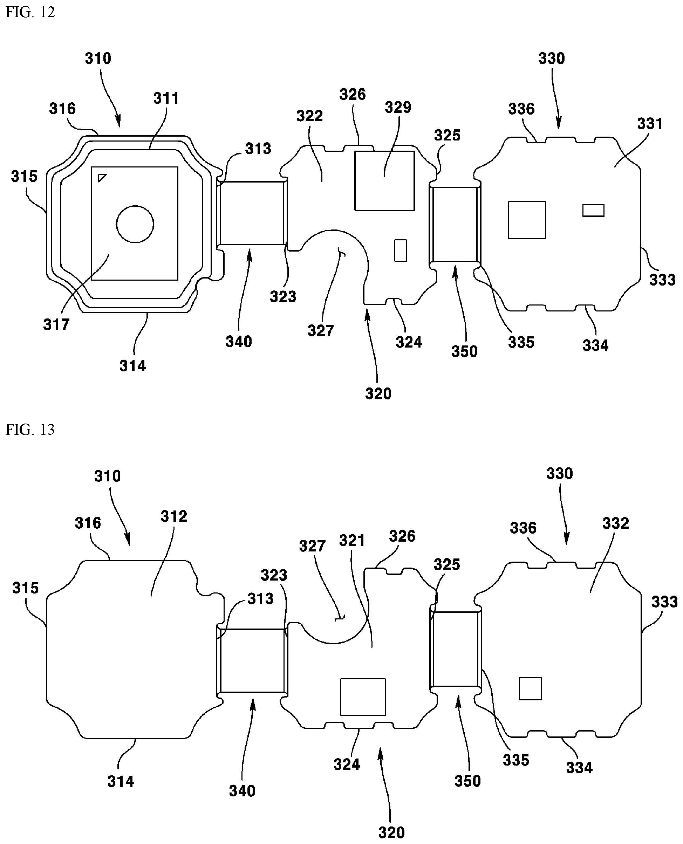

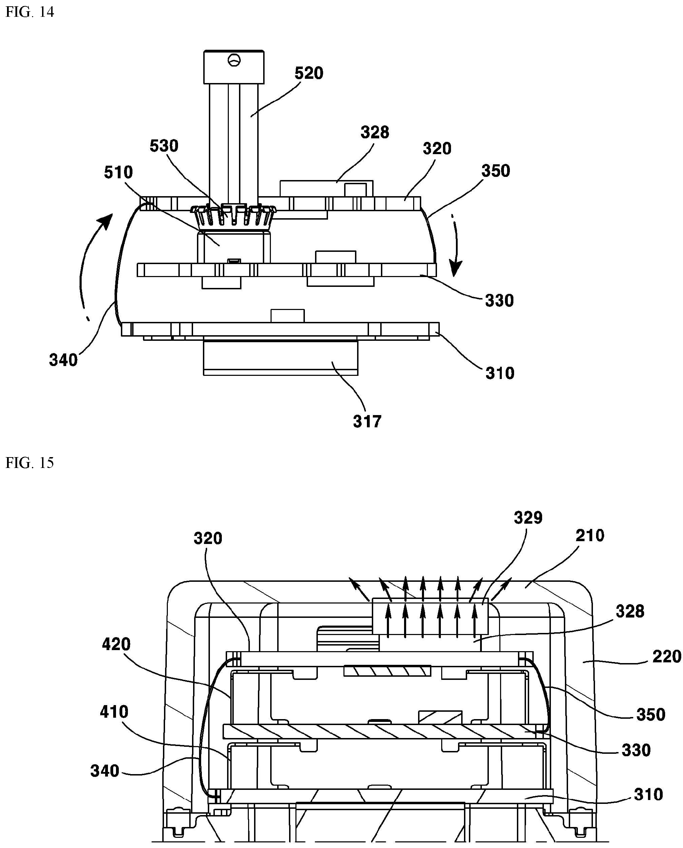

FIG. 1 is a perspective view of a camera module according to the present embodiment when viewed from an upward direction; FIG. 2 is a perspective view of the camera module according to the present embodiment when viewed from a downward direction; FIG. 3 is an exploded perspective view of FIG. 1; FIG. 4 is an exploded perspective view of FIG. 2; FIG. 5 is a perspective view with a second body of a camera module being removed according to the present embodiment; FIG. 6 is a front view of a camera module according to the present embodiment; FIG. 7 is a cross-sectional view taken along line A-A of FIG. 6; FIG. 8 is a cross-sectional view taken along line B-B of FIG. 6; FIG. 9 is a perspective view of a substrate assembly of a camera module according to the present embodiment; FIG. 10 is a perspective view illustrating a substrate assembly and a support member of a camera module according to the present embodiment; FIG. 11 is an exploded perspective view of FIG. 10; FIGS. 12 and 13 are views illustrating an unfolded state of first to fifth substrates of a camera module according to the present embodiment; and FIG. 14 is a side view of a substrate assembly of a camera module according to the present embodiment.

The camera module **10** according to an embodiment of the present invention may be a vehicle camera module. The camera module **10** may be coupled to a vehicle. The camera module **10** may be used in any one or more among a front camera, a side camera, a rear camera, and a black box of a vehicle. The camera module **10** may be disposed in front of a vehicle. The camera module **10** may be disposed at a rear of a vehicle. The camera module **10** may be coupled to a windshield of a vehicle. The camera module **10** may be coupled to a windshield at a front or rear of a vehicle. The camera module **10** may be disposed at a side of a vehicle. The camera module **10** may photograph a subject and output it as an image on a display (not shown).

The camera module **10** may include bodies **100** and **200**. The bodies **100** and **200** may form the outer appearance of the camera module **10**. The bodies **100** and **200** may be formed of a metal material. The bodies **100** and **200** may be metal bodies. The bodies **100** and **200** may include a first body **100** and a second body **200**.

The first body **100** may be disposed above the second body **200**. The first body **100** may be coupled to the second body **200**. The first body **100** may be screw-coupled to the second body **200** by a coupling member **700**.

The first body **100** may include a body part **110**. The body part **110** may have a rectangular plate shape. The cross-sectional area of the body part **110** in a direction perpendicular to the optical axis direction may be larger than the cross-sectional area of the second body **200** in a corresponding direction. The body part **110** may be disposed above the second body **200**. The body part **110** may be coupled to the second body **200**. The body part **110** may be screw-coupled to the second body **200**.

The first body **100** may include a coupling part **120**. The coupling part **120** may be protruded upward from an upper surface **110** of the body part **110**. A lens module **140**, which will be described later, may be disposed in the coupling part **120**. The coupling part **120** may be coupled to the lens module **140**. The coupling part **120** may include a hole **121**. The hole **121** may be formed penetrating through the coupling part **120**, the upper surface of the body part **110**, and the lower **120** surface of the body part **110**. A screw thread **122** may be formed on an inner circumferential surface of the hole **121**. At least a portion of the inner circumferential surface of the hole **121** may include a shape of the screw thread **122**. The inner circumferential surface of the hole **121** may have a shape corresponding to the outer circumferential surface of the lens module **140**. The screw thread **122** of the inner circumferential surface of the hole **121** may have a shape corresponding to the screw thread **141** of the outer circumferential surface of the lens module **140.**

The first body **100** may include a pillar **130** being protruded from a lower surface of the body part **110**. The pillar **130** may include four pillars **130**. The pillar **130** may be formed at positions corresponding to the four corners **230** of the second body **200**. The pillar **130** may be disposed in the groove **240** of the second body **200**. The pillar **130** may include a groove **131**. The groove **131** may be formed by being recessed from the lower end of the pillar **130**. A coupling member **700** may be disposed in the groove **131**. At least a portion of the coupling member **700** may be disposed in the groove **131**. The inner circumferential surface of the groove **131** may have a shape corresponding to the outer circumferential surface of the coupling member **700**. The inner circumferential surface of the groove **131** may include a thread shape. The groove **131** may be screw-coupled to the coupling member **700**. Through this, the first body **100** and the second body **200** may be coupled.

The first body **100** may include a groove **132** being formed on a lower surface of the body part **110**. A second sealing member **160**, which will be described later, may be disposed in the groove **132**. At least a portion of the second sealing member **160** may be disposed in the groove **132**. The protrude part **161** of the second sealing member **160** may be disposed in the groove **132**. The groove **132** may be for fixing the second sealing member **160** being disposed in the first body **100** when the first body **100** and the second body **200** are assembled. The groove **132** may be formed in a round shape at a portion corresponding to the pillar **130**. The groove **132** may be concavely bent at a portion corresponding to the pillar **130**. A portion of the groove **132** facing the pillar **130** may have a round shape. A portion of the groove **132** facing the pillar **130** may be curved in a shape corresponding to the pillar **130**. The round shape of the groove **132** may be for avoiding the pillar **130**.

The camera module **10** may include a lens module **140**. The lens module **140** may be disposed in the first body **100**. The lens module **140** may be disposed in the coupling part **120** of the first body **100**. The lens module **140** may be coupled to the coupling part **120** of the first body **100**. At least a portion of the lens module **140** may be disposed inside the hole **121** of the coupling part **120.** A screw thread **141** may be formed on the outer circumferential surface of the lens module **140**. The screw thread **141** of the lens module **140** may be formed in a shape corresponding to the screw thread **122** of the coupling part **120**. The screw thread **141** of the lens module **140** may be formed to be coupled to the screw thread **122** of the coupling part **120.** The lens module **140** may include a groove **142**. The groove **142** may be formed on an outer circumferential surface of the lens module **140**. The groove **142** may be recessed from an outer circumferential surface of the lens module **140**. The groove **142** may be formed at a position higher than the screw thread **141** on an outer circumferential surface of the lens module **140**. A first sealing member **150** may be disposed in the groove **142**.

The lens module **140** may include a lens. The lens module **140** may include a plurality of lenses. The lens module **140** may include a spacer being disposed between a plurality of lenses. The lens module **140** may be aligned with an image sensor **317**, which will be described later. The lens module **140** may be optically aligned with the image sensor **317**. The optical axis of the lens module **140** may coincide with the central axis of the image sensor **317**. The first body **100** may include an infrared ray filter (IR filter) being disposed between the lens module **140** and the image sensor **317**.

The camera module **10** may include a first sealing member **150**. The first sealing member **150** may be an O-ring. The first sealing member **150** may be formed of an elastic material. The first sealing member **150** may be disposed in the groove **142** of the lens module **140**. At least a portion of the first sealing member **150** may be disposed in the groove **142** of the lens module **140**. The first sealing member **150** may be disposed between the lens module **140** and the coupling part **120** of the first body **100**. The first sealing member **150** may fill a space that may occur between the lens module **140** and the coupling part **120** of the first body **100**. Through this, the lens module **140** may be firmly fixed to the coupling part **120**, and moisture may be prevented from penetrating between the lens module **140** and the coupling part **120**. The first sealing member **150** is disposed between the lens module **140** and the coupling part **120** so that it may perform the role of waterproofing function.

The camera module **10** may include a second sealing member **160**. The second sealing member **160** may be referred to as any one of a gasket and a waterproof member. The second sealing member **160** may be formed of a material having elasticity. The second sealing member **160** may be disposed between the first body **100** and the second body **200**. The second sealing member **160** may be disposed in the groove **132** of the body part **110**. At least a portion of the second sealing member **160** may be disposed in the groove **132** of the body part **110**. The second sealing member **160** may be formed in a shape corresponding to the groove **132** of the body part **110**. The second sealing member **160** may be formed in a shape corresponding to the side surface of the first substrate **310.** The first sealing member **160** may be disposed at an outer side of the first substrate **310**. The second sealing member **160** may be disposed in a space that may occur between the first body **100** and the second body **200**. The second sealing member **160** may be disposed in a separation space of the first body **100** and the second body **200**. The height of the second sealing member **160** in an optical axis direction may be smaller after assembly than before assembly. That is, the second sealing member **160** may be disposed between the first body **100** and the second body **200** in a compressed state in an optical axis direction so that it may perform the role of waterproofing function. Through this, it is possible to prevent moisture from penetrating through the space between the first body **100** and the second body **200**.

The second sealing member **160** may include a protrusion **161**. The protrusion **161** may be protruded upward from an upper surface corresponding to the first body **100** of the second sealing member **160**. The protrusion **161** may be protruded from at least a portion of an upper surface of the second sealing member **160**. The protrusion **161** may be disposed in the groove **121** of the first body **100**. The protrusion **161** may be disposed in the groove **132** of the body part **110** and fixed to the first body **100**. Through this, when the first body **100** and the second body **200** are assembled, the second sealing member **160** may not be separated from the designated position. That is, the second body **200** is assembled in a state where the second sealing member **160** is disposed in the first body **100**, and the protrusion **161** of the second sealing member **160** is inserted into the groove **132** of the body part **110** so that the second body **200** can be assembled without being separated from the designated position. Furthermore, the groove **132** may perform the role of guiding the position of the second sealing member **160**.

The camera module **10** may include a second body **200**. The second body **200** may be referred to as any one among a rear body, a lower housing, and a second housing. The second body **200** may be formed of a metal material. The second body **200** may be a metal body. The second body **200** may be formed in a rectangular shape with an open upper portion. The second body **200** may be disposed below the first body **100**. The second body **200** may be coupled to the first body **100**. The second body **200** may be screw-coupled to the first body **100**. The second body **200** may be disposed below the body part **110** of the first body **100.** The second body **200** may be coupled to the body part **110** of the first body **100**. The second body **200** may form an internal space through coupling with the first body **100**. A second sealing member **160** may be disposed at an upper portion of the second body **200**.

The second body **200** may include a bottom plate **210** and a side plate **220** being extended from the bottom plate **210**. The side plate **220** may be extended upward from an edge of the bottom plate **210**. The second body **200** may include a plurality of side plates **220** and a corner **230** being formed between the plurality of side plates **220**. The second body **200** may include four side plates **220** and four corners **230** being disposed between the four side plates **220**.

The bottom plate **210** may include a hole. A connector withdrawal part **250**, which will be described later, may be disposed in the hole. The connector withdrawal part **250** may penetrate through the hole. The diameter of the hole in a direction perpendicular to the optical axis direction may be the same as the diameter of the outer circumferential surface of the connector withdrawal part **250** in a corresponding direction. The diameter of the hole in a direction perpendicular to the optical axis direction may be larger than the diameter in a corresponding direction of the inner circumferential surface of the connector withdrawal **250.**

The second body **200** may include a groove **240** being formed on an upper surface being coupled to the first body **100**. The grooves **240** may be formed at positions corresponding to the four corners **230** of the second body **200**. The groove **240** may be overlapped with the pillar **130** of the first body **100** in an optical axis direction. The pillar **130** of the first body **100** may be disposed in the groove **240**. The groove **240** may include a bottom surface **241** being disposed at a position lower than the upper surface of the second body **200**. The bottom surface **241** may be in contact with the lower end of the pillar **130**. A hole **242** may be formed in the bottom surface **241**. The hole **242** may be overlapped with the groove **131** of the pillar **130** of the first body **100** an the optical axis direction. A coupling member may penetrate through the hole **242**. The inner circumferential surface of the hole **242** may be formed in a shape corresponding to the outer circumferential surface of the coupling member **700**. The inner circumferential surface of the hole **242** may include a screw thread shape. The coupling member **700** penetrating through the hole **242** may be disposed in the groove **131** of the pillar **130** of the first body **100**.

The second body **200** may include a connector withdrawal part **250**. The connector withdrawal part **250** may be formed in a cylindrical shape. The connector withdrawal part **250** may be coupled to the second body **200**. The connector withdrawal part **250** may penetrate through the hole of the bottom plate **210** of the second body **200**. The connector withdrawal part **250** may be disposed inside the hole of the bottom plate **210** of the second body **200**. At least a portion of the connector withdrawal part **250** may be disposed in the second body **200**, and the remainder of the connector withdrawal part **250** may be exposed toward the outside of the second body **200**.

The connector withdrawal part **250** may be coupled to the bottom plate **210** of the second body **200**. Connectors **510** and **520** may be disposed inside the connector withdrawal part **250**. A second connector **520** may be disposed inside the connector withdrawal part **250**. The connector withdrawal part **250** may include a hole. Connectors **510** and **520** may be disposed in the hole. The hole of the connector withdrawal part **250** may accommodate at least a portion of the connectors **510** and **520**. Through this, the connector withdrawal part **250** can fix the connectors **510** and **520**.

The camera module **10** may include a substrate assembly **300**. The substrate assembly **300** may be disposed inside the second body **200**. The substrate assembly **300** may be disposed in an internal space formed by coupling the first body **100** and the second body **200**.

The substrate assembly **300** may include a first substrate **310**. The first substrate **310** may include a printed circuit board. The first substrate **310** may include a rigid printed circuit board. An image sensor **311** may be disposed in the first substrate **310**. At this time, the first substrate **310** may be referred to as a sensor substrate.

The first substrate **310** may include a first surface **311** facing the first body **100** and a second surface **312** being disposed at an opposite side of the first surface **311**. The image sensor **317** may be disposed on the first surface of the first substrate **310**. The first substrate **310** may be coupled to the first body **100**. The first surface **311** of the first substrate **310** may be coupled to the first body **100**. The first substrate **310** has a first side surface **313** and a second side surface **314**, a third side surface **315** being disposed at an the opposite side of the first side surface **313**, and a fourth side **316** being disposed at an the opposite side of the second side surface **314**.

The first substrate **310** may be disposed above the third substrate **330**. The first substrate **310** may be spaced apart from the third substrate **330** in an optical axis direction. The first substrate **310** may be spaced apart from the third substrate **330** by the first support member **410**. The second surface **312** of the first substrate **310** may face the third substrate **330**. The second surface **312** of the first substrate **310** may face the first surface **331** of the third substrate **330**. The first substrate **310** may be spaced apart from the second substrate **320** in an optical axis direction. The separation distance between the first substrate **310** and the third substrate **330** in an optical axis direction may be smaller than the separation distance between the first substrate **310** and the second substrate **320** in an optical axis direction.

The first substrate **310** may be connected to the second substrate **320**. At least a portion of the first substrate **310** may be connected to the second substrate **320**. The first substrate **310** may be electrically connected to the second substrate **320**. The first substrate **310** may be electrically connected to the second substrate **320** by a fourth substrate **340**, which will be described later. The first substrate **310** may be connected by the second substrate **320** and the fourth substrate **340**.

The first substrate **310** may be connected to the fourth substrate **340**. At least a portion of the first substrate **310** may be connected to the fourth substrate **340**. The first substrate **310** may be electrically connected to the fourth substrate **340**. One end of the fourth substrate **340** may be disposed on the first side surface **313** of the first substrate **310**. The first side surface **313** of the first substrate **310** may be coupled to one end of the fourth substrate **340**.

The substrate assembly **300** may include a second substrate **320**. The second substrate **320** may include a printed circuit board. The second substrate **320** may include a rigid printed circuit board. The second substrate **32** may be referred to as an image sensor processor (ISP) substrate. The second substrate **320** may be disposed below a third substrate **330**, which will be described later. The second substrate **320** may be disposed at a position closer to the bottom plate **210** of the second body **200** than the first substrate **310** and the third substrate **330**. The second substrate **320** may be spaced apart from the first substrate **310**. The second substrate **320** may be spaced apart from the third substrate **330** in an optical axis direction. The separation distance between the second substrate **320** and the first substrate **310** in an optical axis direction may be greater than the separation distance between the second substrate **320** and the third substrate **330** in an optical axis direction. The second substrate **320** may be disposed parallel to the first substrate **310**. The second substrate **320** may be disposed parallel to a third substrate **330**, which will be described later. The second substrate **320** may be spaced apart from the bottom plate **210** of the second body **200** in an optical axis direction. The second substrate **320** may include a first surface **321** facing the third substrate **330** and a second surface **322** being disposed at an opposite side of the first surface **321**. The first surface **321** of the second substrate **320** may face the second surface **332** of the third substrate **330**. The second surface **322** of the second substrate **320** may face the bottom plate **210** of the second body **200**. A processor **328** may be disposed on the second surface **322** of the second substrate **320**.

The second substrate **320** has a first side surface **323** and a second side surface **324**, a third side surface **325** being disposed at an opposite side of the first side surface **323**, and a fourth side surface **326** being disposed at an opposite side of the third side surface **324**.

The second substrate **320** may include a groove **327**. The groove **327** may be formed to be recessed inwardly from a side surface of the second substrate **320**. The groove **327** may be recessed from at least a portion of the first side surface **321** of the second substrate **320**. The groove **327** may be recessed from at least a portion of the fourth side surface **326** of the second substrate **320**. The groove **327** may have a round shape at least in part. A connector **500** may be disposed in the groove **327**. The connector **500** may penetrate through the groove **327**. The groove **327** may be overlapped with the connector **500** in a direction perpendicular to the optical axis direction. The groove **327** may not be overlapped with the first connector **510** of the connector **500** in a direction perpendicular to the optical axis direction. The groove **327** may be overlapped with the second connector **520** of the connector **500** in a direction perpendicular to the optical axis direction. The groove **327** may be spaced apart from the connector **500**. The groove **327** may be formed to avoid the connector **500**. Through this, the connector **500** may be disposed in the third substrate **330** being disposed between the first substrate **310** and the second substrate **320**.

The second substrate **320** may include a processor **328**. The processor **328** may be an image sensor processor (ISP) device. The processor **328** may be a device that converts RGB signals (red, green, and blue signals) of the image sensor **317** into signals visible to the naked eye. The processor **328** may be a device that converts a raw Bayer pattern signal of the image sensor **317** into a signal visible to the naked eye.

The processor **328** may be disposed in the second substrate **320**. The processor **328** may be disposed on the second surface **322** of the second substrate **320**. The processor **328** may be disposed between the second surface **322** of the second substrate **320** and the bottom plate **210** of the second body **200**. The processor **328** may face the bottom plate **210** of the second body **200**. The processor **328** may be spaced apart from the bottom plate **210** of the second body **200** in an optical axis direction. A heat dissipation pad **329**, which will be described later, may be disposed on the processor **328**. The processor **328** may dissipate more heat so that the camera module **10** can output a high-resolution image.

The second substrate **320** may be connected to the first substrate **310**. The second substrate **320** may be electrically connected to the first substrate **310**. The second substrate **320** may be electrically connected to the first substrate **310** by the fourth substrate **340**. The second substrate **320** may be connected to the third substrate **330**. The second substrate **320** may be electrically connected to the third substrate **330**. The second substrate **320** may be electrically connected to the third substrate **330** by a fifth substrate **350**, which will be described later.

The substrate assembly **300** may include a third substrate **330**. The third substrate **330** may include a printed circuit board. The third substrate **330** may include a rigid printed circuit board. The third substrate **330** may be a serializer PCB. The third substrate **330** may change the current supplied through the connector **500** into a stable current. The third substrate **330** may convert the current supplied through the connector **500** into a stable current value and supply it to the second substrate **320**. The third substrate **330** may convert the current supplied through the connector **500** into a stable current value and supply it to the processor **328**. The third substrate **330** may convert the current supplied through the connector **500** into a stable current value and supply it to the first substrate **310**. The third substrate **330** may convert the current supplied through the connector **500** into a stable current value and supply it to the image sensor **317**. The current value supplied through the connector **500** in the vehicle is different from the current value required by the components such as the second substrate **320** and the processor **328**, but the third substrate **330** is supplied through the connector **500**. It may play the role of converting a current to a current value required by components such as the second substrate **320** and the processor **328** and supply the current to the corresponding components.

The third substrate **300** may include a first surface **331** and a second surface **332** being disposed at an opposite side of the second surface **331**. The third substrate **300** may include a first side surface **333** and a second side surface **334**, a third side surface **335** being disposed at an opposite side of the first side surface **333**, and a fourth side surface **336** being disposed a second side surface **334**.

The third substrate **330** may be disposed below the first substrate **310**. The third substrate **330** may be disposed above the second substrate. The third substrate **330** may be disposed between the first substrate **310** and the third substrate **330**. The third substrate **330** may be disposed parallel to the first substrate **310**. The third substrate **330** may be disposed parallel to the second substrate **320**. The first surface **331** of the third substrate **330** may face the first substrate **310**. The first surface **331** of the third substrate **330** may face the second surface **312** of the first substrate **310**. The second surface **332** of the third substrate **330** may face the second substrate **320**. The second surface **332** of the third substrate **330** may face the second surface **321** of the second substrate **320**.

The third substrate **330** may be electrically connected to the connector **500**. A connector **500** may be disposed in the second substrate **330**. A connector **500** may be disposed on the second surface **332** of the third substrate **330**. A first connector **510** may be disposed on the second surface **332** of the third substrate **330**. The third substrate **330** may be electrically connected to the first connector **510**. Through this, the third substrate **330** may receive current from the connector **500**. Through this, the third substrate **330** may supply current to the second substrate **320**.

The third substrate **330** may be connected to a fifth substrate **350**, which will be described later. The third substrate **330** may be electrically connected to the fifth substrate **350**. One end of the fifth substrate **350** may be disposed on the third side surface **335** of the third substrate **330**. The third side surface **335** of the third substrate **330** may be coupled to one end of the fourth substrate **340**.

The substrate assembly **300** may include a fourth substrate **340**. The fourth substrate **340** may include a flexible printed circuit board (FPCB). The fourth substrate **340** may be formed of an elastic material. The fourth substrate **340** may be electrically connected to the first substrate **310**. The fourth substrate **340** may be electrically connected to the second substrate **320**. The fourth substrate **340** may electrically connect the first substrate **310** and the second substrate **320** to each other. One end of the fourth substrate **340** may be coupled to the first substrate **310**. One end of the fourth substrate **340** may be coupled to the first side surface **313** of the first substrate **310**. The other end of the fourth substrate **340** may be coupled to the second substrate **320**. The other end of the fourth substrate **340** may be coupled to the first side surface **323** of the second substrate **320**.

The length of the fourth substrate **340** in an optical axis direction may be longer than the length of the fifth substrate **350**, which will be described later, in the corresponding direction. At least a portion of the fourth substrate **340** may be overlapped with the third substrate **330** in a direction perpendicular to the optical axis direction. The width of the fourth substrate **340** in a direction perpendicular to the optical axis direction may be smaller than the width of the fifth substrate **350** in a corresponding direction. At least a portion of the fourth substrate **340** may be overlapped with the fifth substrate **350** in a direction perpendicular to the optical axis direction.

The substrate assembly **300** may include a fifth substrate **350**. The fifth substrate **350** may include a flexible printed circuit board (FPCB). The fifth substrate **350** may be formed of an elastic material. The fifth substrate **350** may be electrically connected to the second substrate **320**. The fifth substrate **350** may be electrically connected to the third substrate **330**. The fifth substrate **350** may electrically connect the second substrate **320** and the third substrate **330**. One end of the fifth substrate **350** may be coupled to the third substrate **330**. One end of the fifth substrate **350** may be coupled to the third side surface **335** of the third substrate **330**. The other end of the fifth substrate **345** may be coupled to the second substrate **320**. The other end of the fifth substrate **350** may be coupled to the third side surface **325** of the second substrate **320**.

The length of the fifth substrate **350** in an optical axis direction may be longer than the length of the fourth substrate **340** in the corresponding direction. The fifth substrate **350** may not be overlapped with the first substrate **310** in a direction perpendicular to the optical axis direction. The width of the fifth substrate **350** in a direction perpendicular to the optical axis direction may be smaller than the width of the fourth substrate **340** in a corresponding direction.

The camera module **10** may include a heat dissipation pad **329**. A heat dissipation pad **329** may be disposed on the processor **328**. The heat dissipation pad **329** may face the bottom plate **210** of the second body **200**. The heat dissipation pad **329** may be in contact with the bottom plate **210** of the second body **200**. The heat dissipation pad **329** may be formed of a thermally conductive material. The heat dissipation pad **329** may transfer heat emitted from the processor **328** to the second body **200**. The heat dissipation pad **329** may transfer heat emitted from the processor **328** to the bottom plate **210** of the second body **200**. Through this, heat generated by the processor **328** may be transferred to the second body **200** made of metal through the heat dissipation pad **329**, and the heat transferred to the second body **200** may be emitted to the outside. As the heat dissipation pad **329**, a heat dissipation pad **329** having high thermal conductivity may be used according to the internal temperature of the bodies **100** or **200**. That is, the camera module **10** according to the present embodiment may be capable of dissipating heat even if the amount of heat generated by the processor **328** is large by changing or replacing the heat dissipation pad **329**. The thickness of the heat dissipation pad **329** in an optical axis direction may be thicker than the thickness of the processor **329** in an optical axis direction.

The camera module **10** may include a support member **400**. The support member **400** may be referred to as any one among a shield can, a shield member, and a spacer. The support member **400** may be formed of a metal material. The support member **400** may be disposed inside the bodies **100** and **200**. The support member **400** may be disposed inside the second body **200**. The support member **400** may include a plurality of support members **410** and **420**. In the present embodiment, the plurality of support members **410** and **420** will be described as an example of two, but the present invention is not limited thereto and may be variously changed according to the number of substrates. The support member **400** may be disposed between the plurality of substrates to space the plurality of substrates apart in an optical axis direction. The support member **400** may be disposed between the plurality of substrates to support the plurality of substrates. The support member **400** may perform an electromagnetic wave shielding function.

The support member **400** may include a first support member **410**. The first support member **410** may be disposed below the first substrate **310**. The first support member **410** may be disposed above the third substrate **330**. The first support member **410** may be disposed between the first substrate **310** and the third substrate **330**. An upper end of the first support member **410** may be in contact with the first substrate **310**. The upper end of the first support member **410** may be in contact with the second surface **312** of the first substrate **310**. The lower end of the first support member **410** may be in contact with the third substrate **330**. The lower end of the first support member **410** may be in contact with the first surface **331** of the third substrate **330**. At least a portion of the first support member **410** may be overlapped with a second support member **420**, which will be described later, in a direction perpendicular to the optical axis direction.

The support member **400** may include a second support member **420**. The second support member **420** may be disposed in the second substrate **320**. The second support member **420** may be disposed below the third substrate **330**. The second support member **420** may be disposed between the third substrate **330** and the second substrate **320**. An upper end of the second support member **420** may be in contact with the third substrate **330**. The upper end of the second support member **420** may be in contact with the second surface **332** of the third substrate **330**. A lower end of the second support member **420** may be in contact with the second substrate **320**. The lower end of the second support member **420** may be in contact with the second surface **332** of the second substrate **320**. At least a portion of the second support member **420** may be overlapped with a first support member **410**, which will be described later, in a direction perpendicular to the optical axis direction.

The camera module **10** may include a connector **500**. The connector **500** may be disposed inside the bodies **100** and **200**. The connector **500** may be disposed inside the second body **200**. The connector **500** may electrically connect a cable (not shown) and the third substrate **330.** The connector **500** may include a first connector **510** electrically connected to the third substrate **330** and a second connector **520** electrically connecting the first connector **510** and a cable. The first connector **510** may be disposed in the third substrate **330**. The first connector **510** may be disposed on the second surface **332** of the third substrate **330**. The first connector **510** may be electrically connected to the third substrate **330**. At least a portion of the connector **500** may be disposed at a higher position than the second substrate **320**. The remaining part of the connector **500** may be disposed at a lower position than the second substrate **320**.

The first connector **510** may be disposed between the second substrate **320** and the third substrate **330**. The first connector **510** may be spaced apart from the second substrate **320** in an optical axis direction. The first connector **510** may be disposed closer to the third substrate **330** than the second substrate **320**. At least a portion of the first connector **510** may be overlapped with the fourth substrate **340** in a direction perpendicular to the optical axis direction. The first connector **510** may be overlapped with the fifth substrate **350** in a direction perpendicular to the optical axis direction. A ground member **530**, which will be described later, may be disposed in the first connector **510**. The first connector **510** may be integrally formed with the ground member **530**.

The second connector **520** may be electrically connected to the first connector **510**. The second connector **520** may be electrically connected to the cable. The second connector **520** may be disposed inside the connector withdrawal part **250** of the second body **200**. At least a portion of the second connector **520** may be disposed inside the connector withdrawal part **250** of the second body **200**, and the remainder of the second connector **520** may be disposed inside the second body **200**. The second connector **520** may penetrate through the groove **327** of the second substrate **320**. A portion of the second connector **520** may be disposed between the second substrate **320** and the third substrate **330**, and the remaining portion of the second connector **520** may be disposed at a lower position than the second substrate **320**. The second connector **520** may be integrally formed with the ground member **530.**

The second connector **520** may be electrically connected to the first connector **510**. The second connector **520** may be electrically connected to the cable. The second connector **520** may be disposed inside the connector withdrawal part **250** of the second body **200**. At least a portion of the second connector **520** may be disposed inside the connector withdrawal part **250** of the second body **200**, and the remainder of the second connector **520** may be disposed inside the second body **200**. The second connector **520** may penetrate through the groove **327** of the second substrate **320**. A portion of the second connector **520** may be disposed between the second substrate **320** and the third substrate **330**, and the remaining portion of the second connector **520** may be disposed at a lower position than the second substrate **320**. The second connector **520** may be integrally formed with the ground member **530**.

The camera module **10** may include a third sealing member **600**. The third sealing member **600** may be a waterproof member. The third sealing member **600** may be formed of a material having elasticity. The third sealing member **600** may be spaced apart from the ground member **530** in an optical axis direction. The third sealing member **600** may be disposed at a lower position than the second substrate **320**. The third sealing member **600** may be disposed in the second connector **520**. The third sealing member **600** may be disposed inside the second body **200**. The third sealing member **600** may be disposed inside the connector withdrawal part **250** of the second body **200**. Through this, it is possible to prevent moisture from penetrating between the second body **200** and the connector **500**.

The camera module **10** may include a coupling member **700**. The coupling member **700** may couple the first body **100** and the second body **200**. The coupling member **700** may screw-couple the first body **100** and the second body **200** to each other. The coupling member **700** may include a bolt. The coupling member **700** may include a screw. A thread may be formed on the outer circumferential surface of the coupling member **700**. The coupling member **700** may be coupled to the hole **242** of the second body **200**. The coupling member **700** may penetrate the hole **242** of the second body **200**. The coupling member **700** penetrating through the hole **242** of the second body **200** may be disposed in the groove **131** of the pillar **130** of the first body **100**. Through this, the coupling member **700** may couple the first body **100** and the second body **200**.

Hereinafter, a heat dissipation path of the camera module **10** according to the present embodiment will be described in detail with reference to the drawings.

FIG. 15 is a diagram illustrating a heat dissipation path of a camera module according to the present embodiment.

Recently, as a camera module outputs a high-resolution image, the number of substrates increases, and the size and number of devices mounted on the substrate increase. At this time, since the amount of heat generated from the substrate or an element mounted on the substrate is increased, the temperature inside the camera module is rising, so there is an issue about a heat dissipation structure that radiates heat to the outside.

Referring to FIG. 15, heat generated from the processor **328** is transferred to the heat dissipation pad **329**, and the heat transferred to the heat dissipation pad **329** may be transferred to the second body **200** made of a metal material to be discharged toward the outside. Through this, heat inside the bodies **100** and **200** may be radiated to the outside to lower the temperature. As a modified embodiment, the camera module **10** may not include the heat dissipation pad **329**. In this case, the heat generated from the processor **328** may be transferred to the second body **200** to be discharged toward the outside.

The camera module **10** according to the present embodiment changes the assembly structure of the substrates **310**, **320**, and **330** so that it is possible to design in a way that the processor **328**, which generates a lot of heat, can be to arranged in a position adjacent to the bottom plate **210** of the second body **200**. In addition, by changing the assembly structure of the substrates **310**, **320**, and **330**, it is possible to design a structure advantageous for heat dissipation by making contact with a component such as a heat dissipation pad **329** having high thermal conductivity. In addition, the heat dissipation performance may be improved by changing the area, thickness, and material of the heat dissipation pad **329**.

The embodiments of the present invention have been described above with reference to the accompanying drawings, but a person skilled in the art to which the present invention belongs may understand that the present invention can be implemented in other specific forms without changing the technical spirit or essential features. Therefore, it should be understood that the embodiments described above are illustrative and non-limiting in all respects.

### [ITEMS]

[Item 1]A camera module comprising:
   a first body comprising a lens;
   a second body coupled to the first body; and
   a substrate assembly disposed inside the second body,
   wherein the substrate assembly comprises:
      a first substrate and a second substrate;
      a third substrate disposed between the first substrate and the second substrate;
      a fourth substrate electrically connecting the first substrate and the second substrate;
      a fifth substrate electrically connecting the second substrate and the third substrate; and
      a processor disposed on the second substrate, and
      wherein a length of the fourth substrate is longer than a length of the fifth substrate.
[Item 2]The camera module according to item 1,
   wherein the processor is disposed closer to a bottom plate of the second body than the first to fifth substrates.
[Item 3]The camera module according to item 1,
   wherein at least a portion of the fourth substrate is overlapped with the second substrate in a direction perpendicular to an optical axis direction.
[Item 4]The camera module according to item 1,
   wherein the fourth substrate is overlapped with the fifth substrate in a direction perpendicular to an optical axis direction.
[Item 5]The camera module according to item 1, comprising:
   a connector disposed on the third substrate,
   wherein the second substrate comprises a groove through which the connector is being penetrated.
[Item 6]The camera module according to item 5,
   wherein at least a portion of the connector is overlapped with the second substrate in a direction perpendicular to an optical axis direction.
[Item 7]The camera module according to item 5,
   wherein at least a portion of the connector is disposed at a position higher than the second substrate, and
   wherein the remaining portion of the connector is disposed at a position lower than the second substrate.
[Item 8]The camera module according to item 1,
   wherein a distance between the first substrate and the second substrate in an optical axis direction is longer than a distance between the first substrate and the third substrate in the optical axis direction.
[Item 9]The camera module according to item 1,
   wherein the second body comprises a bottom plate, a side plate extended upwardly from the bottom plate, and
   wherein the camera module comprises a heat dissipation pad disposed between the processor and the bottom plate of the second body,
   wherein one surface of the heat dissipation pad is in contact with the processor, and
   wherein the other surface of the heat dissipation pad is in contact with the bottom plate of the second body.
[Item 10]A camera module comprising:
   a first body comprising a lens;
   a second body coupled to the first body; and
   a substrate assembly disposed inside the second body,
   wherein the substrate assembly comprises:
      a first substrate and a second substrate;
      a third substrate disposed between the first and second substrates;
      a fourth substrate electrically connecting the first substrate and the second substrate;
      a fifth substrate electrically connecting the second substrate and the third substrate; and
      a processor disposed on the second substrate, and
      wherein a length of the fourth substrate in an optical axis is longer than a length of the fifth substrate in the optical axis.

## Claims

1. A camera module comprising:
a first body (100) comprising a lens;
a second body (200) coupled to the first body (100);
a substrate assembly (300) disposed inside the second body (200) and comprising a plurality of substrates; and
a support member (400) disposed between the plurality of substrates,
wherein the support member (400) comprises a first support member (410) and a second support member (420), and
wherein at least a portion of the first support member (410) overlaps the second support member (420) in a direction perpendicular to an optical axis direction.

2. The camera module according to claim 1,
wherein the support member (400) spaces the plurality of substrates apart from each other in the optical axis direction.

3. The camera module according to claim 1 or claim 2,
wherein the support member (400) is formed of a metal material and shields electromagnetic waves.

4. The camera module according to any one of claims 1 to 3,
wherein the substrate assembly (300) comprises:
a first substrate (310) and a second substrate (320);
a third substrate (330) disposed between the first substrate (310) and the second substrate (320) in the optical axis direction;
a fourth substrate (340) electrically connecting the first substrate (310) and the second substrate (320);
a fifth substrate (350) electrically connecting the second substrate (320) and the third substrate (330); and
a processor (328) disposed on the second substrate (320), and
wherein a length of the fourth substrate (340) is longer than a length of the fifth substrate (350).

5. The camera module according to claim 4,
wherein the first support member (410) is disposed between the first substrate (310) and the third substrate (330), and
wherein the second support member (420) is disposed between the second substrate (320) and the third substrate (330).

6. The camera module according to claim 5,
wherein an upper end of the first support member (410) is in contact with the first substrate (310), and
wherein a lower end of the first support member (410) is in contact with the third substrate (330).

7. The camera module according to claim 5 or claim 6,
wherein an upper end of the second support member (420) is in contact with the third substrate (330), and
wherein a lower end of the second support member (420) is in contact with the second substrate (320).

8. The camera module according to any one of claims 4 to 7,
wherein the processor (328) is disposed closer to a bottom plate of the second body (200) than the first to fifth substrate (350)s.

9. The camera module according to any one of claims 4 to 8,
wherein at least a portion of the fourth substrate (340) overlaps the second substrate (320) in a second direction perpendicular to the optical axis direction.

10. The camera module according to any one of claims 4 to 9,
wherein the fourth substrate (340) overlaps the fifth substrate (350) in a second direction perpendicular to the optical axis direction.

11. The camera module according to claim 6,
wherein at least a portion of the connector overlaps the second substrate (320) in a second direction perpendicular to the optical axis direction.

12. The camera module according to claim 6 or claim 11,
wherein at least a portion of the connector is disposed at a position higher than the second substrate (320), and
wherein a remaining portion of the connector is disposed at a position lower than the second substrate (320).

13. The camera module according to any one of claims 4 to 12,
wherein a distance between the first substrate (310) and the second substrate (320) in the optical axis direction is longer than a distance between the first substrate (310) and the third substrate (330) in the optical axis direction.

14. The camera module according to any one of claims 4 to 13,
wherein the second body (200) comprises a bottom plate and a side plate extending upwardly from the bottom plate,
wherein the camera module comprises a heat dissipation pad (329) disposed between the processor (328) and the bottom plate of the second body (200),
wherein one surface of the heat dissipation pad (329) is in contact with the processor (328), and
wherein the other surface of the heat dissipation pad (329) is in contact with the bottom plate of the second body (200).

15. The camera module according to claim 14,
wherein the heat dissipation pad (329) is formed of a thermally conductive material.
